# EUROPEAN PATENT APPLICATION

(11) **EP 1 705 698 A2**
(43) Date of publication of application: **27.09.2006**
(21) Application number: 06005989.6
(22) Date of filing: 23.03.2006
(51) Int. Cl.: H01L 21/20, H01L 21/762

(54) **Method of fabricating strained silicon on an SOI substrate**

(30) Priority: 25.03.2005 JP 2005090084
(71) Applicant: SUMCO Corporation, Minato-ku Tokyo (JP); Kyushu University, National University Corporation, Fukuoka-shi Fukuoka-ken (JP)
(72) Inventor: Ninomiya, Masaharu, Minato-ku, Tokyo (JP); Matsumoto, Koji, Minato-ku, Tokyo (JP); Nakamae, Masahiko, Minato-ku, Tokyo (JP); Miyao, Masanobu, Higashi-ku Fukuoka-shi Fukuoka-ken (JP)
(74) Representative: Albrecht, Thomas

(57) **Abstract**

A strained Si-SOI substrate is produced by a method comprising: growing a SiGe mixed crystal layer on an SOI substrate having a Si layer of not less than 5 nm in thickness and a buried oxide layer; forming a protective film on the SiGe mixed crystal layer; implanting light element ions into a vicinity of an interface between the silicon layer and the buried oxide layer; a first heat treatment for heat treating the substrate at a temperature of 400 to 1000°C in an inert gas atmosphere; a second heat treatment for heat treating the substrate at a temperature not lower than 1050°C in an oxidizing atmosphere containing chlorine; removing an oxide film from the surface of the substrate, and forming a strained silicon layer on the surface of the substrate.

## Description

### BACKGROUND OF THE INVENTION

### Field of the Invention

The present invention relates to a strained Si-SOI (Silicon-On-Insulator) substrate of high quality and a method for producing the same. Specifically, the present invention relates to a technology for reducing surface roughness, decreasing number of defects, and improving quality of SOI wafers having a relaxed SiGe layer and a strained Si layer on an oxide film layer. Priority is claimed on Japanese Patent Application No. 2005-090084, filed March 25, 2005, the content of which is incorporated herein by reference.

### Description of Related Art

High speed current and low power consumption in silicon MOS devices have been realized compatibly depending on the Scaling law, for example, by minimizing device size, or by decreasing operation voltage. However, it is difficult to retain such a compatible effects within a micro device having a gate length of not more than 100 nm.

Accordingly, introduction of SOI substrates and strained silicon substrates has been studied recently. Especially, there have been carried out various investigations on production methods of SOI wafers provided with strained silicon.

A first method combines an SOI substrate and an SiGe (silicon germanium) formed by epitaxial technique. For example, Japanese Unexamined Patent Application, First Publication, No. H7-169926 describes a method in which a relaxed SiGe layer is formed by epitaxial growth of SiGe on an SOI substrate, and a layer of a strained Si (silicon) is formed by the epitaxial grown of Si layer on the relaxed SiGe.

As a second method, Japanese Unexamined Patent Application, First Publication No.H9-321307 describes a method for forming a strain relaxed SiGe on a buried oxide layer (BOX layer) using an SIMOX (Separation by IMplanted OXygen) method.

As a third method, Japanese Unexamined Patent Application, First Publiaction No. 2000-243946 describes a method for relaxation of strain by forming a SiGesfilm on an SOI substrate, subsequently heat-treating the substrate in an oxidizing atmosphere, and thereby causing downward diffusion of Ge, thinning of the SiGe layer and Ge enrichment in the layer.

As a fourth method, Japanese Unexamined Patent Application, First Publication No. 2003-31495 describes a method for strain relaxation of an SiGe layer by forming a SiGe layer on an SOI substrate, melting the SiGe layer by heat treatment, and subsequently solidifying the SiGe layer while diffusing Ge in the layer.

As a fifth method, Japanese Unexamined Patent Application, First Publication No. H10-308503 describes a method for forming a relaxed SiGe layer on a SiGe layer having step-wise variation of Ge content within the layer formed on an SOI wafer.

As a sixth method, a method for forming a strained silicon-SOI substrate in which only strained silicon exists in a buried oxide layer utilizing a bonding method is described in page 8 to 9 of Extended Abstracts of the 2002 International Conference on Solid State Devices and Materials (ISSDM2002, Nagoya, 2002).

However, the above described first to fifth methods concern methods for forming a relaxed SiGe layer on an insulator which is formed on a Si substrate, and forming strained Si on the SiGe layer. For example, in the case of using a buffet layer in which Ge content increases with moderate gradient, generation of dislocations causes surface irregularities on the SiGe surface. Such surface irregularities reflect the distribution of dislocation lines and include lattice like steps called cross-hatches. Since the surface irregularities have an adverse effect on the photo-lithography which is carried out during a device-production process, it is needed to remove the irregularities. Conventionally, a similar step for polishing the Si has been applied to the steptfor polishing the SiGe. However, even after the polishing step, penetrating dislocation densities and surface roughness of the SiGe layer have been in an insufficient state compared with the desirable level for a device or a desirable level for raw materials for device production. Especially, the above described cross-hatches are not uniformly distributed. At intervals of about several µms, the cross-hatches generate relatively large steps of about several tens of nm in height. It has been difficult to polish off such surface irregularities of cross-hatches during polishing of the SiGe using a general method for polishing the Si.

In the sixth method, only a strained Si layer is formed on an insulator layer which is formed on a Si substrate. However, the bonding method for making The strained Si-SOI substrate requires epitaxial growth of a thick strained Si/Ge layer and plurality of steps including a bonding step, exfoliation step, and film thinning step. Therefore, such a method has involved high production cost.

In order to overcome such a problem, in Japanese Unexamined Patent Application, First Publication No. 2004-363198, the inventors disclosed a method for producing a semiconductor substrate comprising a Si substrate and an SiGe layer epitaxially grown on the Si substrate. The method comprises a film formation step of epitaxially growing an SiGe layer on an Si substrate; an oxide film formation step subsequent to the film formation step of the SiGe layer by oxidizing an upper surface of the SiGe layer; and an oxide film removal step subsequent to the oxide film formation step for removing the oxide film by etching. In this method, after forming sequentially an amorphous SiGe layer having a predetermined Ge content and an amorphous silicon thin foil on an SOI substrate, hydrogen ions are implanted in the interface between the BOX layer and the Si layer in the SOI substrate. The substrate is subjected to heat treatment at least once at a predetermined temperature in an oxidizing atmosphere. Subsequently, the substrate is subjected to a heat treatment for melting the amorphous SiGe layer and the amorphous silicon layer. After the removal of the oxide film, a strained silicon is formed.

The above described method raises the problem of relatively long operation time for melting the amorphous SiGe layer and amorphous Si layer, and removal of the oxide layer. Therefore, there has been a demand for shortening the operation time, and further alleviation of roughness and defect status of a substrate surface.

In accordance with the above described circumstances, the present invention aims to provide a method for producing a strained silicon-SOI substrate havingsa flat surface and low defect density in a short operation (production) time. Another object of the present invention is to provide a strained Si-SOI substrate produced by the method.

### SUMMARY OF THE INVENTION

Based on extensive investigation on the strain relaxation process of SiGe layers formed on SOI substrates, the inventors found the following method which can provide, on an Si oxide layer of an SOI substrate, a strain relaxed SiGe layer and strained Si layer both having low defect density and a flat surface.

A production method of a strained Si- SOI substrate of the invention comprises: growing a SiGe mixed crystal layer on an SOI substrate having an Si layer of not less than 5 nm in thickness and a buried oxide layer; forming a protective film on the SiGe mixed crystal layer; implanting light element ions into a vicinity of an interface between the silicon layer and the buried oxide layer; a first heat treatment for heat treating the substrate at a temperature of 400 to 1000°C in an inert gas atmosphere; a second heat treatment for heat treating the substrate at a temperature not lower than 1050°C in an oxidizing atmosphere including chlorine; removing an Si oxide film which is formed on a surface of the substrate; and forming a strained Si layer on the substrate. By this method, the above-described problem is overcome.

The SiGe mixed layer may be an epitaxial layer.

The protective film may be an Si layer, a vapor growth SiO₂ film, or a multi layered film of Si and vapor growth SiO₂ (a film comprising at least one Si layer and at least one SiO₂ film).

The light element may be selected from a group consisting of hydrogen, helium, fluorine, and neon.

In the case of using hydrogen as the light element, a dose of ion implantation may be not less than 1×10¹⁴ atoms/cm², and not more than 1×10¹⁷ atoms/cm².

Preferably, the first heat treatment may include low temperature treatment at a temperature of 400 to 650°C, and high temperature treatment at a temperature of 650 to 1000°C.

The strained Si layer may be formed by epitaxial growth.

During the second heat treatment, the diffusion rate of Ge may be higher than a film formation rate of the silicon oxide.

Atmospheric gas for the second heat treatment may contain gaseous substance containing chlorine such that an amount of chlorine in the atmosphere is equivalent to chlorine molecule of not less than 1% and not more than 30% in molar ratio.

Being produced by the above described production method, the strained Si-SOI substrate of the invention overcomes the above-described problems.

In the above described method for producing a strained Si-SOI substrate, light element ions implanted after the formation of the SiGe mixed crystal layer weaken a bonding strength between the single crystalline Si layer and the insulating layer of buried oxide. During the second heat treatment, Ge diffusion from the SiGe layer to the Si layer changes the Si layer into a SiGe layer. At the same time, in an oxidizing atmosphere containing chlorine, oxidization of Si in the SiGe layer forms an Si oxide film on the surface of the SiGe layer. As a consequence, Ge concentration increases in the SiGe layer with decreasing film thickness of the SiGe layer. Also in the second heat treatment, light element ions implanted in the substrate weaken the bonding strength between the SiGe layer and the buried insulator (buried oxide) layer. Next, after removing the surface oxide film, a strained Si layer is formed on the surface of the substrate. Since the above described method decreases the bonding strength between the single crystalline Si layer and the buried insulator layer, relaxation of strainitends to occur in the SiGe mixed crystal layer, and it is possible to obtain a relaxed SiGe layer and a strained Si layer both having few defects and a flat surface.

In the above described method, by performing the second heat treatment in an oxidizing atmosphere containing chlorine, it is possible to decrease the numbers of defects on the surface of the strained Si-SOI substrate, and increase the degree of relaxation of the SiGe layer. By performing the first heat treatment in an inert gas atmosphere, the light elements are caused to concentrate at the interface between the single crystalline Si layer and the buried oxide layer, and weaken the bonding strength between the single crystalline Si layer and the buried oxide layer.

By having the SiGe mixed crystal layer be an epitaxial layer, it is possible to flatten the interface between the SiGe mixed crystal layer and the strained Si layer, and decrease the defect density.

By forming the protective film with a Si layer, a vapor growth SiO₂ flm, or a multi layered film of the Si layer and SiO₂ film, that is, by using an Si layer, SiO₂ layer, or a compound layer comprising at least one Si and one SiO₂ layers, it is possible to prevent evaporation loss of Ge from the surface of the SiGe layer during the heat treatment. Therefore, roughness of the surface of the SiGe mixed layer is effectively controlled.

By selecting the light element from a group comprising hydrogen, helium, fluorine, and neon, such elements implanted by the ion implantation are caused to weaken the bonding strength between the single crystalline Si layer and the buried oxide layer, and enhance the strain relaxation of the SiGe mixed crystal layer. Therefore, it is possible to obtain an SiGe layer and a strained Si layer formed on the SiGe layer both having few defects and a flat surface.

For implanting fluorine, neon, or helium ions instead of hydrogen ions; the dose of ions being implanted may be determined in inverse proportion to the atomic weight of the element per atomic weight of hydrogen. For example, a dose for helium implantation may be one fourth of the dose for hydrogen implantation.

In the invention, the first heat treatment preferably comprises a low temperature heat treatment at a temperature range of 400 to 650°C and a high temperature heat treatment at a temperature range of 650 to 1000°C. By this treatment, hydrogen, helium, fluorine, or neon implanted in the vicinity of the interface between the single crystalline Si layer and the buried oxide layer is caused to concentrate at the interface during the low temperature step, and weaken the bonding strength between the single crystalline Si layer and the buried oxide layer during the subsequent high temperature step. By performing such two stage heat treatments during the first heat treatment, it is possible to effectively weaken the bonding strength between the single crystalline Si layer and the buried oxide layer. Because of the reduction of the bonding strength, strain relaxation of the SiGe layer tends to occur in the second heat treatment, and low defect density and featness of surface of the SiGe layer and the strained Si layer are easily obtained.

By forming the strained Si layer by epitaxial growth, the interface between the SiGe layer and the strained Si layer is flattened and defects are decreased in number.

By having the conditions of the second heat treatment such that a diffusion rate of Ge is always higher than the growth rate of the Si oxide film, Ge of the SiGe layer can be caused to sufficiently diffuse into the Si layer of the SOI substrate. At the same time, Si of the SiGe layer is oxidized and the silicon oxide film is effectively grown. Under such conditions, increase in Ge concentration and decrease in film thickness of the SiGe layer may be performed with a short period of time, and therefore, workability is sufficiently increased.

Since a strained Si-SOI substrate of the invention is produced by the above described method, the strained Si layer of the strained SI-SOI substrate has a flat and low defect surface.

A representative embodiment of the production method of a strained Si-SOI substrate of the invention includes the following steps:
A SiGe layer (a SiGe mixed crystal layer) is formed on a Si layer of an SOI substrate, and a protective film comprising at least a layer (protective film) selected from an Si layer and an SiO₂ film is formed on the SiGe layer; Subsequently, light element ions such as hydrogen, helium, fluorine, or neon ions are implanted into a vicinity of an interface between the single crystalline silicon layer and a buried oxide layer;
In a heat treatment (a first heat treatment ) at a temperature of 400 to 1000°C, the implanted ions are caused to concentrate at the interface between the single crystalline Si layer and a buried oxide layer;
In a heat treatment (a second heat treatment ) at a temperature not lower than 1050°C in an oxidizing atmosphere, Ge is diffused from a SiGe layer into the single crystalline Si layer and changes the Si layer into an additional SiGe layer, but the thickness of the SiGe layer gradually decreases with increasing thickness of the oxide film formed by surface oxidization of the SiGe layer; Simultaneously, relaxation of the SiGe layer is caused to occur, and interfacial slip is enhanced to occur at the interface between the SiGe layer and the buried oxide layer;
After removing the surface oxide layer, a strained Si layer is formed by epitaxialy growing a Si/SiGe layer or a Si layer on the SiGe layer.

In the above described steps, heat treatment temperatures are controlled to be lower than the solidus temperature depending on the Ge content of the solid state SiGe layer.

The following are points regarding the invention.
1. Hydrogen, helium, fluorine, or neon ions implanted in the vicinity of the interface between a single crystalline Si layer and a buried oxide layer of an SCI substrate concentrate at the interface during a first heat treatment at 400 to 1000°C and weaken a bonding strength between the single crystalline Si layer and the buried oxide layer.
2. Since the bonding strength between the single crystalline silicon layer and the buried oxide layer is reduced, relaxation of the SiGe layer tends to occur during the second heat treatment at a temperature not lower than 1050°C in an oxidizing atmosphere containing chlorine.
3. In the second heat treatment at a temperature not lower than 1050°,; in an oxidizing atmosphere, it is effective for reducing defects, to control the conditions of the heat treatment such that a diffusion rate of Ge is higher than a film formation rate of a surface Si oxide film.
4. In the second heat treatment at a temperature not lower than 1050°C in an oxidizing atmosphere, it is effective to control the atmosphere to be an oxidizing atmosphere containing chlorine to reduce defects and to enhance the degree of relaxation.
5. An oxide film formed on the surface of substrate is removed, and a strained Si layer is formed by epitaxial growth of an Si layer.

In the present invention, a production method of a strained Si-SOI substrate comprises: growing an SiGe mixed layer on an SOI substrate having an Si layer of not less than 5 nm and less than 100 nm in thickness, and a buried oxide layer; forming a protective film on the SiGe mixed layer; implanting ions into a vicinity of the Si layer and the buried oxide layer; a first heat treatment for heat treating the substrate at a temperature of 400 to 1000°C in an inert gas atmosphere; a second heat treatment for heat treating the substrate at a temperature not less than 1050°C in an oxidizing atmosphere containing chlorine; and forming a strained Si layer. By the heat treatment in an oxidizing atmosphere containing chlorine, Ge is caused to diffuse into the Si layer from the SiGe mixed crystal layer and therby change the Si layer into a SiGe mixed layer. At the same time, the light element implanted weakens the bonding strength between the single crystalline silicon layer and the buried oxide layer, and thereby enhances strain relaxation of the SiGe mixed crystal layer. Accordingly, it is possible to obtain a relaxed SiGe layer and a strained Si layer having a low defect density and a flat surface.

### BRIEF DESCRIPTION OF THE DRAWINGS

FIGS. 1A to 1F are cross sectional views of substrates indicating steps for a production method of strained silicon-SOI substrate of the invention.
FIG. 2 is a process chart of an embodiment of a production method of a strained Si-SOI substrate of the invention.
FIG 3 is a cross sectional view of an embodiment of a strained Si-SCl substrate of the invention.
FIG. 4 is a graph (phase diagram) showing a solidus of an Si-Ge system,
FIG 5 is a process chart indicating another embodiment of a production method of a strained Si-SOI substrate of the invention.
FIG. 6A is a photograph showing a surface of a conventional substrate.
FIG 6B is a photograph showing a strained Si-SOI substrate of the invention.
FIG 7 is a graph showing film thickness of silicon oxide depending on an operation time and a chlorine concentration in an atmosphere.

### DETAILED DESCRIPTION OF THE INVENTION

### First embodiment

A first embodiment of a production method of a strained Si-SOI substrate of the invention is explained with reference to the drawings.

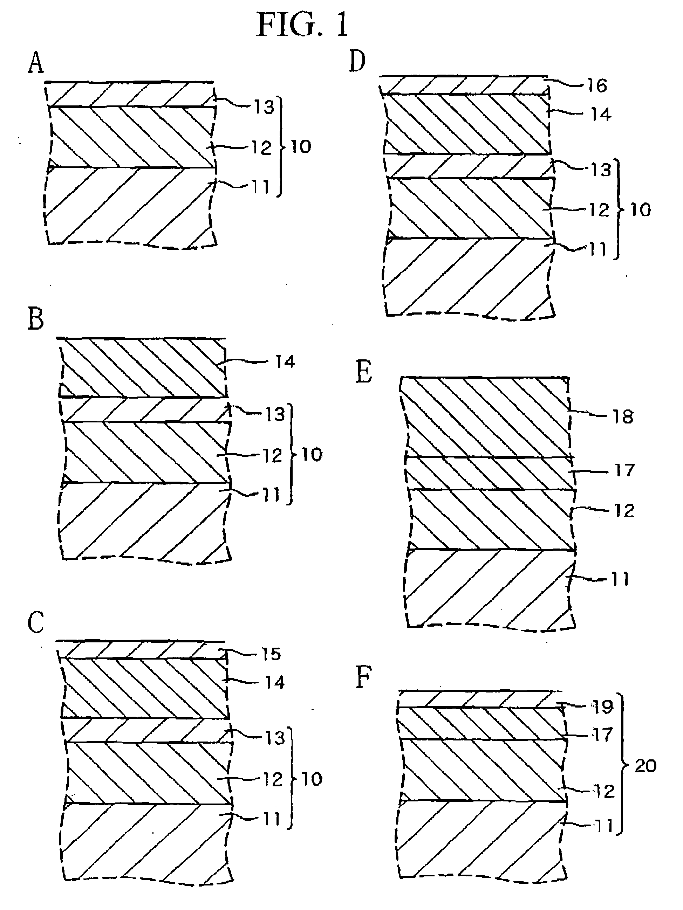

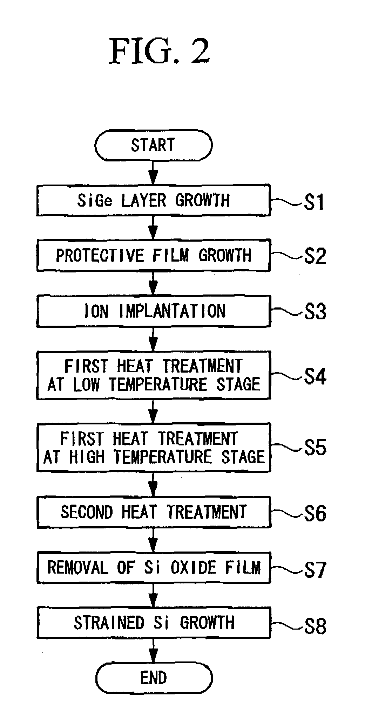

FIGS.1A to 1F are cross sectional views of substrates showing a production process of a strained Si-SOI substrate. FIG.2 is a process chart showing a production method of a strained Si-SOI substrate in the embodiment. In FIG 1 the SOI substrate is indicated by numeral 10.

A strained Si-SOI substrate is produced by the following method.

Firstly, an SOI substrate 10 is prepared. The SOI substrate 10 comprises an insulator layer (buried oxide layer) 12 on an Si substrate 11, and a single crystalline Si layer (Si layer) 13 on the insulator layer 12. For example, as the SOI substrate 10, it is possible to use an SOI substrate produced by the SIMOX (Separation by IMplanted OXgen) method. In the SIMOX method, by oxygen implantation from a surface of a wafer, a buried oxide layer (a BOX layer) is formed in a portion having a predetermined depth from the wafer surface. Alternatively, the SOI substrate 10 may be a bonded SOI wafer produced by bonding a support wafer and an active wafer which is processed a thin film. The active layer of the bonded SOI substrate may be processed a thin film by mechanical processing, chemical etching or vapor phase etching. The bonded SOI substrate may also be formed by the Smart-Cutting method or by the ELTRAN method. In the Smart-Cutting method, hydrogen ions are implanted to a predetermined depth in the active wafer, and using the implanted layer as a starting point, the wafer is cut parallel to the wafer surface. In the ELTRAN method, a porous polycrystalline Si layer is formed in a substrate before bonding of the two substrates, and the bonded substrate is cut at the polycrystalline Si layer.

The thickness of the Si layer 13 of the SOI substrate 10 is not less than 5 nm. In an SOI substrate formed by SIMOX method, the thickness of the Si layer is controlled to be 5 to 100 nm. In an SOI substrate formed by the bonding method, the thickness of the Si layer is 5 to 500nm or more. As an example of the insulator layer 12, an SiO₂ film may be formed.

As a next step shown in S of FIG. 2, as shown in FIG 1B, an SiGe mixed crystal layer (a SiGe layer) 14 is formed on the Si layer 13 of the SOI substrate. The SiGe mixed crystal 14 may be formed using an apparatus for molecular beam epitaxy (MBE). In this case, after setting a substrate in the MBE apparatus, silicon and germanium are supplied into the apparatus, and the SiGe mixed crystal layer is grown as an epitaxial layer on the Si layer 13. Alternatively, the SiGe mixed layer 14 may also be formed by a chemical vapor deposition ( CVD ) method.

As a next step shown in S3 of FIG. 2, as shown in FIGS. 1C and 1D, a protective film is formed on the SiGe mixed crystal layer 14. The protective film is formed to inhibit evaporation of Ge from the surface of the substrate during the subsequebt heat treatment.

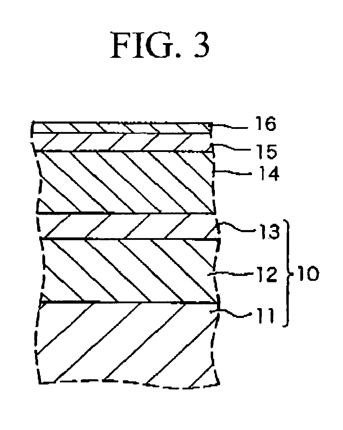

The protective film may be formed as a Si layer 15 as shown in FIG. C, an SiO₂ film 16 as shown in FIG. 1D, or as shown in FIG. 3, as a composite film comprising a Si layer 15 and a SiO₂ film 16 which is formed on the Si layer 15.

In the case of using an Si layer 15 as the protective film as shown in FIG. 1C, during a below-described heat treatment in an oxidizing atmosphere, an oxide film (SiO₂ film) is formed, and thereby evaporation of the Ge is effectively prevented. The Si layer 15 may also be used to control a Ge concentration of the SiGe mixed crystal layer after the heat treatment.

In a case in which the protective film is formed as an SiO₂ film 16 shown in FIG 1D, or a composite layer of an Si layer 15 and an SiO₂ film 16 as shown in FIG 3, evaporation of Ge is inhibited during the below-described heat treatment in an inert gas atmosphere. A protective film of the Si layer 15, SiO₂ film 16, or a composite layer of these layers may be formed by a vapor phase growth method on the SiGe layer 14, As the vapor phase growth method, an MBE method, an UHV-CVD (Ultra High Vicuum Chemical Vapor Depositiom) method, or a CVD method may be employed. When the protective film is formed by the MBE method, after forming the SiGe mixed crystal layer 14, supply of germane gas (gaseous germanium hydride) is stopped, and the Si layer 15 is formed. For forming the SiO₂ film, or the composite film, for example, after forming the Si layer 15 by stopping the supply of germane gas, the substrate is extracted from the MBE apparatus, and is transferred into an electric furnace, and is heated at a temperature of not more than 900°C in an oxidizing atmosphere to oxidize a portion or the whole of the Si layer 15,

As a next step shown in S3 of FIG 2, ions of a light element such as hydrogen or helium are implanted so that an interface between the insulator layer 12 and the Si layer 13 (hereafter referred as the interface A) or a vicinity of the interface A show a highest concentration of the light element ions.

The ion implantation is performed in order to enhance relaxation of the insulator layer 12 and a below-described SiGe mixed crystal layer 17. For such relaxation, the interface A between the insulator layer 12 and a SiGe layer 17 must show a relaxation. For this purpose, the interface A may be controlled to have the highest ion concentration. Alternatively, a portion of the insulator layer 12 or the SiGe layer 13 in the vicinity of the interface A may have the highest ion concentration, since the ions may concentrated at the interface A during the subsequent first heat treatment step.

For example, the interface A and its vicinity may be controlled to be 0 to 30 nm in distance from the interface A in the direction of thickness.

In a case of implanting hydrogen ions (H⁺), preferably, the dose of implanted ions may be controlled to be 1×10¹⁴ to 5×10¹⁶atoms/cm². More preferably, the hydrogen ion dose may be controlled to be 1×10¹⁵ to 1 ×10¹⁶atoms/cm². When the dose of ion implantation is less than 1×10¹⁴atoms/cm², the degree of relaxation of the SiGe layer indicated as a peak shift of Raman spectrum in Raman Spectroscopy does not show a sufficient value. Therefore, it is preferable to control the hydrogen ion dose to be not less than 1×10¹⁴atoms/cm². On the other hand, too high an ion dose generates bubbles of about a several µm in sizes and 1×10¹⁴/cm² in density, and thereby disarrange the crystallinity of the SOI substrate 10. Therefore, the hydrogen ion dose is preferably not more than 5×10¹⁶atoms/cm².

Instead of implanting hydrogen, or along with implanting hydrogen, helium ions (He⁺) may be implanted. In this case, the dose of helium ions is preferably 25×10¹³ to 1.25 × 10¹⁶atoms/cm². More preferably, the helium ion dose may be controlled to be 2.5×10¹⁴ to 5×10¹⁵ atoms/cm². It is also possible to implant fluorine or neon.:

A portion being implanted with ions, including a portion of highest ion concentration is formed parallel to the interface A of the insulator layer 12 and the Si layer 15.

After the ion implantation, as a first heat treatment step shown as S4 and S5 in FIG 2, the substrate is subjected to a low temperature heat treatment at a temperature range of 400 to 650°C in an inert gas atmosphere, and a high temperature treatment at a temperature range of 650 to 1000°C in an inert gas atmosphere. By such firstiheat treatment, without oxidizing the SiGe layer 14, hydrogen, helium, fluorine, or neon implanted into the vicinity of the interface A of the single crystalline Si layer 13 and the buried oxide layer 12 of the SOI substrate 10 are caused to concentrate at the interface A, and weaken the bonding strength of the single crystalline Si layer 13 and the buried oxide layer 12. By performing the two stage heat treatment during the first heat treatment step, the bonding strength between the single crystalline silicon layer and the buried oxide layer may be effectively weakened.

In the above described heat treatment, a gas for the inert gas atmosphere may be a nitrogen gas, Ar gas, or helium gas.

Next, as a second heat treatment shown as S6 in FIG.2, as shown in FIG. 1E, the substrate implanted with ions is heat treated at a temperature (for example at 12,0°C) not lower than 1050°C and lower than the solidus temperature in an oxidizing atmosphere containing chlorine.

The oxidizing atmosphere for the heat treatment may be an atmosphere containing Cl₂ or an atmosphere containing gaseous HCl. Being converted to the molar ratio of chlorine molecules, chlorine content in the oxidizing atmosphere for the second heat treatment may be 1 to 30%, preferably 5 to 30%. Using such an atmosphere, defects on the suface of the SiGe layer 17 may be reduced in number and the degree of relaxation of the SiGe layer may be effectively improved.

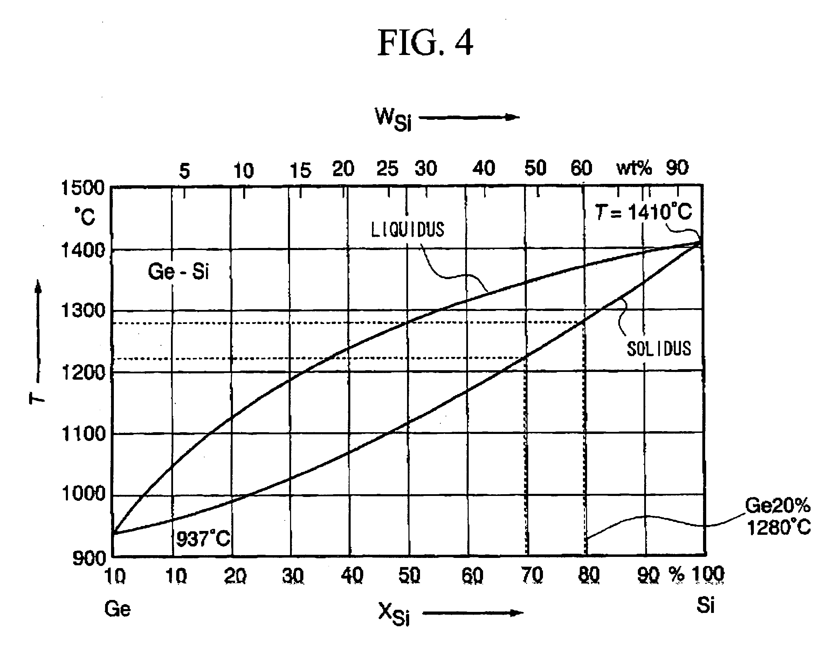

The heat treatment temperature must be lower than a solidus temperature of the SiGe system. As shown in the phase diagram of Si-Ge system in FIG 4, the solidus temperature depends on the concentration of Ge. The lower horizontal axis of FIG 4 indicates an Si content X_{Si} in atomic % in the SiGe, and the longitudinal axis indicates a temperature (°C). In this graph, the upper curve is called the liquidus. Above the liquidus temperature, SiGe is completely molten and is in liquid phase. The lower curve is called the solidus. Below the solidus temperature, the system is in a solid state. Under conditions shown as a region between the liquidus and the solidus, the system is at a state of partial melting. Therefore, in the present embodiment, the heat treatment temperature is controlled to be lower than the solidus temperature in order to awoid melting of the SiGe mixed crystal.

A time period for the heat treatment is controlled such that all of the Sir layer 13 and the SiGe layer 14 is converted to the SiGe layer 17 by Ge diffusion from the SiGe layer 14 to the single crystalline Si layer 13, and an Si oxide film 18 is grown to have a predetermined thickness. As an example of a preferable heat treatment conditions, for a case in which the SiGe mixed crystal is 100 nm in thickness and 30 atomic % in Ge concentration, and the Si layer on the insulator layer is 100 nm in thickness, the heat treatment temperature is set at 1210°C, and the time period for the heat treatment is set to be 2 hours.

By this heat treatment, Ge is caused to diffuse into the Si layer 13 from the SiGe layer 14, and forms the SiGe layer 17. At the same time, in an oxidizing atmosphere, Si of the SiGe layer is oxidized, and therefore the SiO₂ film 16 is thickened to form an Si oxide film 18. The Ge content in the SiGe layer and the thickness of the Si oxide film 18 increase with decreasing thickness of the SiGe layer. As a result, the SiGe layer 17 having a Ge content higher than that of the SiGe layer 14 is formed. That is, by the oxidization of the SiGe layer, Ge is concentrated in the SiGe layer.

The heat treatment conditions are controlled such that a diffusion rate of Ge is always higher than the growth rate of the Si oxide film 18. In such conditions, Ge diffuses sufficiently into the Si layer 13 from the SiGe layer 14. In addition, the Si oxide film 18 is effectively grown, and the concentration of Ge content and reduction of thickness of the SiGe layer are effectively performed in a short time period, and thereby workability is improved.

A relation between the ion dose in the ion implantation step and a degree of peak shift of a Raman spectrum obtained after the subsequent heat treatment and removal of the oxide film is explained hereinafter. In a case in which hydrogen ions are not implanted, the substrate does not show sufficient peak shift of a Raman spectrum when the substrate is analyzed by an apparatus for Raman spectroscopy. That is, the SiGe layer of the substrate does not show sufficient relaxation. On the other hand, a substrate which is implanted with hydrogen ion in a dose of not less than I ×10⁴atoms/cm² and subsequently heat treated for not shorter than 110 minutes, shows a sufficient peak shift of a Raman spectrum corresponding to the Ge content. That is, in this case, the SiGe layer is sufficiently relaxed.

As a next step as shown in S7 of FIG 2, the Si oxide film 18 is removed. Subsequently, as step S8 of FIG.2, as shown in FIG 1F, a strained Si layer 19 is formed. Thus a strained Si-SOI substrate 20 comprising the insulator layer 12, SiGe layer 17, and the strained Si layer 19 on the Si substrate 11 can be formed.

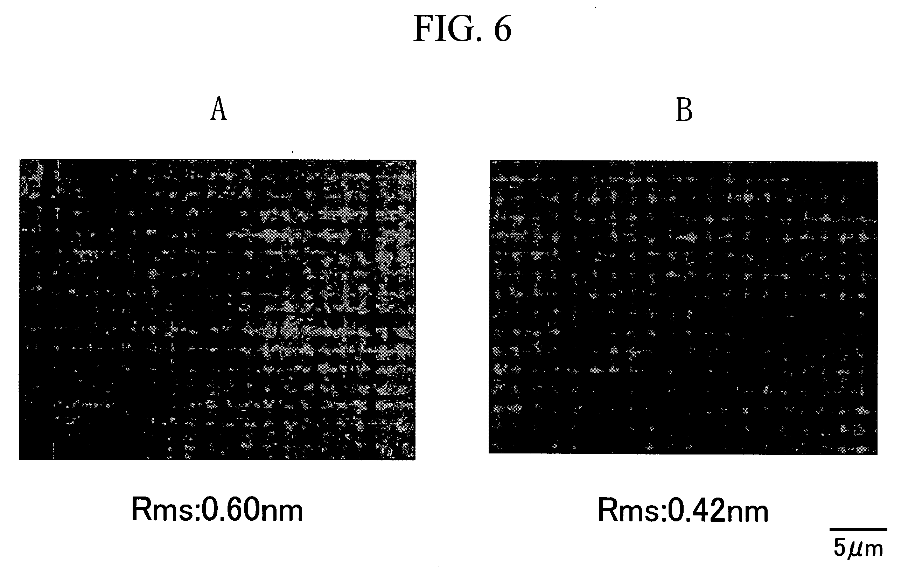

Since the above-described strained Si-SOI substrate 20 is heat treated in the first heat treatment comprising two stage heat treatments at low and high temperature in an inert gas atmosphere, and the second heat treatment in an oxidizing atmosphere containing chlorine, surface roughness of the substrate can be controlled to be not more than 0.45 nm in RMS, That is, the substrate shows excellent flatness. In addition, penetrating dislocation density can also be reduced to a low value such as 5 × 10⁴/cm² As an example of the substrate produced by the present embodiment, FIG. 6B shows a substrate having a surface RMS: 0.42 nm. This substrate is greatly reduced in cross-hatches compared with the substrate having a surface RMS: 0.60 nm shown in FIG 6A as an example of a substrate produced by a conventional method.

### Second embodiment

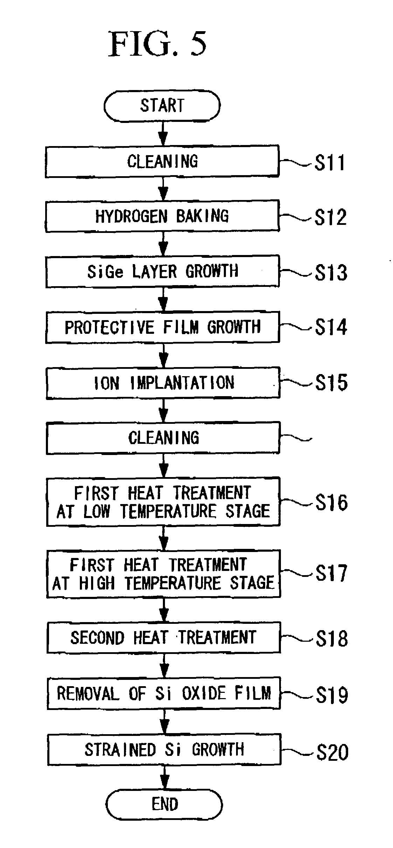

Next, a second embodiment of a production method of a strained Si-SOI substrate is explained with reference to the drawings. FIG 5 is a process chart showing the production method of a strained Si-SOI substrate in accordance with the second embodiment. An explanation for the elements corresponding to the elements of the first embodiment is omitted because the same symbols are used.

An SOI wafer 10 is prepared to comprise an Si layer 13 of not less than 5 nm in thickness in a buried oxide layer 12.

The SOI substrate may be produced by a known method such as the SIMOX method, or a bonding method (e.g., Smart-Cutting method, or ELTRAN method).

As a next step shown in S 11 of FIG 5, the SOI substrate 10 for forming a SiGe layer 14 is subjected to cleaning. The method for cleaning the SOI substrate may be selected from conventional cleaning methods such as SC-1+SC-2 cleaning, cleaning with a mixing solution of HF/O₃, and reciprocal cleaning alternately using an HF solution and an O₃ solution.

After cleaning the SOI substrate 10, as a step S12 of FIG 5, hydrogen baking treatment S12 is performed before epitaxial growth of an SiGe layer in order to ensure that the wafer 10 has a clean surface free of oxygen and carbon impurities by removing spontaneous surface oxide film or the like.

The hydrogen baking treatment is performed at a temperature range of 900 to 1200°C. An atmosphere for the hydrogen baking treatment may be controlled to have normal pressure or a reduced pressure. The pressure may depend on the apparatus for the epitaxial growth.

Next, as a step S13 of FIG 5, a SiGe layer 14 is epitaxially grown on the surface of the SOI wafer 10. A lamp heater type CVD apparatus, or an MBE apparatus may be used as an apparatus for the epitaxial growth. For example, for the epitaxial growth of the SiGe layer 14 using a lamp heater type CVD apparatus, it is preferable to control the temperature to be not more than 1000°C, and more preferably, at 500 to 800°C. The ambient pressure is generally controlled to be a reduced pressure not more than 13330 Pa (100 torr). It is important to control the thickness of the SiGe layer to be not thicker than a critical thickness. The critical thickness is a minimum thickenss for occurrence of dislocation and depends on the epitaxial growth temperature and Ge concentration of the SiGe layer.

Before the epitaxial growth of the SiGe layer 14, an Si seed layer may be formed on the surface of the SOI wafer 10. By forming the Si seed layer, it is possible to improve surface conditions of the SOI wafer 10, and thereby improve the film formation state of the SiGe layer 14. For example, it is possible to form the Si seed layer in advance for forming the SiGe layer 14 by not feeding germane gas, but only feeding a gaseous raw material for silicon such as silane gas or the like into the apparatus for the epitaxial growth. The thickness of the Si seed layer may be controlled to be an appropriate value. For example, for obtaining a thin film of the SiGe layer of not more than 100 nm in thickness, it is preferable to form a thin Si seed layer of 5 to 30 nm in thickness, in view of a reduction of processing time.

After the epitaxial growth of the SiGe layer 14, as a step S 14 of FIG 5, an Si layer 15 is epitaxailly grown on the SiGe layer 14.

As a protective film, an SiO₂ film 16 is formed on the Si layer 1 using a CVD method. The SiO₂ film 16 may be formed as a thin layer provided that the thickness is sufficient for inhibiting the worsening of surface roughness of the Si layer 1S. For example, the SiO₂ film 16 may be 20 to 30 nm in thickness. It is also possible to form the SiO₂ film 16 of 10 to 20 nm in thickness as a protective film by oxidizing the above described Si layer 15.

As a step S15 in FIG 5, hydrogen ions are implanted into the vicinity of an interface A of the single crystalline Si layer 13 and the buried oxide layer 12. The ion dose is controlled to be 5×10¹⁴ to 1×10¹⁷ atoms/cm², preferably 3×10¹⁵ to 2×10¹⁶atoms /cm². The depth of ion implantation is preferably selected as an appropriate depth depending on the thickness of the Si layer/SiGe layer/Si layer on the buried oxide layer.

After the ion implantation, as steps S16 and S 17 of FIG 5, the substrate is annealed at 400 to 1000°C (a first heat treatment). It is preferable to perform the annealing in an inert gas atmosphere. It is preferable that the annealing comprise a first stage heat treatment (S16) at 400 to 650°C and a second stage heat treatment (S17) at 650 to 1000°C.

During the first stage heat treatment (S16), implanted ions concentrate in the vicinity of the interface between the single crystalline Si layer 13 and the buried oxide layer 12. During the second stage heat treatment (S 17), bonding strength of the single crystalline Si layer 13 and the buried oxide layer 12 is reduced. By this treatment, during subsequent heat treatment at not lower than 1050°C, interface slip between the SiGe layer 17 and the oxide film 12 is enhanced, and the SiGe layer 17 is easily relaxed.

Next, as a step S 18 of FIG. 5, the substrate is heat treated at a temperature' not lower than 1050°C in oxidizing conditions. The purpose of this step is to ensure that the SiGe layer 17 has a desired thickness and Ge concentration by diffusing Ge from the SiGe layer 14 to the Si layer 13, and by forming an Si oxide layer 18. Another purpose of this step is to generate interface slips at the interface between SiGe layer 17 and the buried oxide layer 12. At the temperature region not lower than 1050°C, the diffusion rate of Ge in the Si layer 13 is higher than the oxidization rate of the surface of the SiGe layer 17in an oxidixing atmosphere. Therefore, without the occurrence of heterogeneous distribution of Ge, such as an occurrence of localized portions of high Ge content, Ge is homogeneously distributed throughout the SiGe layer 17, and the interface between the SiGe layer 17 and the buried oxide layer generates interface slips. As a result, the SiGe layer 17 in which relaxation is enhanced shows a homogeneotas distribution of Ge concentration in the depth direction.

In the second heat treatment, it is preferable to use a temperature as high as possible, and not lower than 1100°C, but below the solidus temperature.

In the above-described heat treatment at a temperature not lower than 1050°C, the oxidizing atmosphere may contain gaseous substance containing chlorine such that an amount of chlorine in the atmosphere is equivalent to chlorine molecule of not more than 10% in molar ratio. In this case, since the chlorine content in the oxidizing atmosphere enhances the formation rate of the Si oxide film 18, it is necessary to control the oxygen partial pressure of the atmospheric gas in order to satisfy the condition that the diffusion rate of the Ge in the Si is higher than the formation rate of the Si oxide film 18.

As described above, the oxygen partial pressure in the oxidizing atmosphere may be controlled so as to ensure that the diffusion rate of the Ge in the Si is higher than the oxidization rate of the Si.

It is important to control the heat treatment temperature to be lower than the solidus temperature corresponding to the final Ge content of the SiGe layer 17 to prevent a melting of the SiGe layer 17.

In addition, as a step S19 of FIG 5, from the SOI wafer comprising the SiGe layer 17 and the Si oxide film on the buried oxide layer 12, the oxide film 18 is removed using a dilute HF water solution. Alternatively, another conventional method for example, a method using a buffered HF solution or an ammonium fluoride solution may be applied.

As a next step shown in S20 of FIG. 5, the SOI wafer is introduced in the apparatus for epitaxial growth and a spontaneous oxide film of the wafer surface is removed by hydrogen baking or the like. After that, a strained Si layer 19 is epitaxially grown on the SiGe layer 17. The strained Si layer is formed to be thinner than a critical thickness which depends on the Ge content of the SiGe layer 17 and the growth temperature. Before the growth of the strained Si layer 19, it is possible to grew an SiGe layer.

For example, the hydrogen baking may be performed at a temperature of not lower than 750°C and lower than 900°C. A time period for the hydrogen baking is preferably 30 seconds to 5 mimutes. At a temperature of not lower than 900°C, an Si layer is formed on the SiGe layer 17 by evaporation of Ge. In that case, if the strained Si layer is epitaxialy grown on the substrate, there is a possibility of the thickness of the strained Si layer exceeding the critical thickness and the interface between the strained Si layer 19 and the SiGe layer may have defects. Therefore, a temperature of not lower than 900°C is not preferable. On the other hand, at 750°C, hydrogen baking for longer than 5 minutes shows no obvious effect compared to hydrogen baking for not longer than 5 minutes. The atmospheric pressure is preferably controlled to be reduced pressure. For the epitaxial growth of Si, gaseous raw materials containing silicon, such as disilane, mono-silane, or dichlorosilane may be fed to the growth apparatus.

As explained above, a strained Si-SOI substrate 20 of the embodiment is formed.

### Examples

### 1) Example 1

P-type SOI substrates of 200 mm in diameter were prepared by the SIMOX method. In each wafer, a thickness of a single crystalline Si layer 13 on a buried oxide layer 12 was 50 nm, and a thickness of the buried oxide layer 12 was 140 nm.

Subsequently, after cleaning of each SOI wafer (SOI substrate) 10 by the SC-1+SC-2 cleaning method, the wafer was immediately introduced to the lamp heater type single wafer type epitaxial growth apparatus.

Before the epitaxial growth of the SiGe layer, the SOI wafer was subjected to a hydrogen baking treatment. For the baking, the temperature was at 1125°C, atmospheric pressure was 2666 Pa (20 torr), a hydrogen flow rate was 20 SLM (liter per minutes at standard state), and the time was 45 seconds.

After cleaning of the surface of the substrate 10 by hydrogen baking treatment, a SiGe layer 14 was epitaxially grown. The thickness of the SiGe layer was 100 nm, and its Ge concentration was 10 atomic %.

For this epitaxial growth, temperature was set at 730°C, atmospheric pleasure was 2666 Pa (20 torr), hydrogen flow rate was 20 SLM, and silane gas and germane gas were fed as raw materials. Next, a protective film of Si 15 of 5 nm in thickness was epitaxially grown by stopping the feed of germane gas, setting the temperature at 700°C and maintaining the other conditions the same as those for growing the SiGe.

Next, a wafer was extracted, and an Si oxide (SiOs) film 16 of 20 nm in thickness was formed using a plasma CVD apparatus.

Next, after forming the oxide film on each SOI wafer 10, using an apparatus for ion implantation, using conditions such that a portion of highest ion concentration was located at the interface between the Si layer 13 and the buried oxide layer 12, hydrogen ions were implanted into each wafer in doses of 3×10¹⁴, 5×10¹⁴, 1×10¹⁵, 5×10⁵, 1×10¹⁶ , 3×10¹⁶ , 5×10¹⁶ atoms/cm² respectively.

In addition, an SOI wafer which was not implanted with ions was prepared. The SiGe layer 14 and the protective film were also formed in this wafer.

Next, the wafers were extracted from the implantation apparatus, and both sides of each wafer were cleaned. After that, the wafers were subjected to a heat treatment.

The wafers were treated at 500°C for 30 minutes, and after that, at 850°C for 2 hours. A nitrogen gas atmosphere was used as the atmosphere for the heat treatment.

Next, the temperature was reduced to 700°C, and the atmosphere was changed to a nitrogen atmosphere containing oxygen at 3 mol % (molar ratio of oxygen molecules in the atmosphere). After that, the temperature was increased to 1200°C, and the atmosphere was changed to an oxygen gas atmosphere. Under these conditions, each wafer was treated for 1.5 hours. Subsequently, the atmosphere was changed to an oxgen gas atmosphere containing 3 mol% of HCI, and the wafers were heat treated under these conditions for 30 minutes. After that, the atmosphere was changed to nitrogen atmosphere containing 3 mol % of oxygen, the temperature was reduced to 700°C, and then the SOI wafers 10 were extracted.

Next, an oxide film formed on the surface of the SOI wafer was removed using dilute HF water containing HF of 10% by weight. The solution was maintained at room temperature and the wafers were immersed in the solution for 20 minutes. After that, the wafers were immersed in pure water for 15 minutes. Immediately after spin drying the wafer, the wafer was introduced to a lamp heater type single wafer type epitaxial growth apparatus and an Si layer of 5 nm in thickness was epitaxially grown on the surface of the SiGe layer 17. As conditions for growing the Si layer, temperature was set at 700°C, atmospheric pressure was controlled to be 2666 Pa (20 torr), and mono-silane gas was fed with hydrogen flow of 20 SLM.

For each of the above described hydrogen implantation doses, one wafer was subjected to analysis of degree of relaxation using an apparatus for Raman spectroscopy. In addition, surface roughness of each wafer was measured using an AFM (Atomic Force Miroscope).

A laser beam of 443 nm in wavelength was used for the Raman spectroscopy. An area of 20µm×20µm was subjected to AFM analysis.

Next, each wafer was divided into four pieces. One piece of each wafer was etched by way of Secco etching and was analyzed for penetrating dislocation density.

Etching was carried out to the depth of 30 nm from the surface. The numbers of etch pits were counted using a differential interference microscope.

Using another piece of each wafer, thickness and Ge concentration of the SiGe layer were analyzed using SIMS (Secondary Ion Mass Spectroscopy).

The results are summarized in Table 1.

**Table 1.**

| | 1 | 2 | 3 | 4 | 5 | 6 | 7 | 8 |
|---|---|---|---|---|---|---|---|---|
| Hydrogen Ion Implantation atoms/cm² | nd | 3.00E+14 | 5.00E+14 | 1.00E+15 | 6.00+15 | 1.00E+16 | 3.00E+10 | 5.00E+16 |
| Degree of Relaxation % | 65 | 80 | 88 | 92 | 91 | 92 | 91 | 92 |
| Penetrating Dislocation Density /cm² | 7.00E+06 | 7.00E+05 | 7.00E+04 | 3.00E+04 | 3.30E+04 | 3.00E+04 | 3.40E+04 | 4.00E+04 |
| Ge content atomic % | 22 | 21. 9 | 22.1 | 22.1 | 21-9 9 | 22.1 | 22 | 22 |
| Tichkness of SiGe layer nm | 45 | 45.1 | 45.1 | 44.9 | 45 | 44.9 | 45.1 | 45 |
| Surface Roughness nm | 0.6 | 0.45 | 0.4 | 0.38 | 0.35 | 0.39 | 0.39 | 0.41 |

From this table, it was confirmed that compared to the wafer not implanted with hydrogen, an effect of strain relaxation was obvious in the wafer implanted with hydrogen in a dose of not less than 3 × 10¹⁴ atoms/cm².

If the hydrogen implantation dose exceeds 5×10¹⁶ atoms/cm², bubbles of several µm in sizes appear in the wafer with a density of about 1 × 10⁴/cm², and lower the surface quality.

### 2) Comparative Example 1

In this Comparative Example 1, strained Si-SOI wafers were prepared for each hydrogen implantation dose described in Example 1 using conditions in which HCl was not added in the oxidization heat treatment (second heat treatment), but the other conditions were simlar to those of Example 1.

For each of the above described hydrogen implantation doses, one wafer was subjected to analysis of degree of relaxation of SiGe using the apparatus for Raman spectroscopy. In addition, surface roughness of each wafer was measured using AFM.

A laser beam of 443 nm in wavelength was used for the Raman speemscopy. An area of 20µm × 20 µm was subjected to the AFM analysis.

Next, each wafer was divided into four pieces. One piece of each wafer was etched by way of Secco etching and was analyzed for penetrating dislocation density.

Etching was carried out to the depth of 30 nm from the surface. The numbers of etch pits were counted using the differential interference microscope.

Using another piece of each wafer, thickness and Ge concentration of the SiGe layer were analyzed using SIMS.

The results are summarized in Table 2.

**Table 2.**

| | 1 | 2 | 3 | 4 | 5 | 6 | 7 | 8 |
|---|---|---|---|---|---|---|---|---|
| Hydrogen Ion Implantation atoms/cm² | nd | 3.00E+14 | 5.00E+14 | 1.00E+15 | 5.00E+15 | 1.00E+16 | 3.00E+16 | 5.00E+16 |
| Degree of Relaxation % | 60 | 80 | 86 | B8 | B5 | 88 | 88 | 88 |
| Penetrating Dislocation Density /cm² | 1.00E+07 | 1.00E+06 | 5.00E+05 | 3.00E+06 | 1.00E+05 | 1.00E+06 | 1.00E+06 | 1.00E+05 |
| Ge content atomic % | 20.1 | 20 | 20.1 | 20.1 | 20.1 | 20. 05 | 20 | 20 |
| Tichkness of SiGe layer nm | 50 | 50.1 | 50.1 | 50,2 | 50 | 49.9 | 50 | 50.1 |
| Surface Roughness nm | 0.6 | 0.5 | 0.51 | 0.48 | 0.49 | 0.5 | 0.49 | 0.49 |

### 3) Example 2

P-type SOI substrates 10 of 200 mm in diameter were prepared by the SIMOX method. In each wafer, a thickness of a single crystalline Si layer 13 on a buried oxide layer 12 was 50 nm, and a thickness of the buried oxide layer 12 was 140 nm.

Subsequently, after cleaning of each SOI wafer (SOI substrate) 10 by the SC-1+SC-2 cleaning method, the wafer was immediately introduced to the lamp heater type single wafer type epitaxial growth apparatus.

Before the epitaxial growth of the SiGe layer 14, the SOI wafer was subjected to a hydrogen baking treatment. For the baking, the temperature was set at 1128°C, atmospheric pressure was 2666 Pa (20 torr), a hydrogen flow rate was 20 SLM, and the time was 45 seconds. After cleaning of the surface of the substrate 10 by hydrogen baking treatment, a SiGe layer 14 was epitaxially grown. The thickness of the SiGe layer was 140 nm, and its Ge concentration was 10 atomic %.

For this epitaxial growth, temperature was set at 730°C, atmospheric pressure was 2666 Pa (20 torr), hydrogen flow rate was 20 SLM, and silane gas and germane gas were fed as raw materials. Next, a Si layer 15 of 5 nm was formed by stopping the feed of germane gas, setting the temperature at 700°C and maintaining the other conditions the same as those for growing the SiGe.

Next, each wafer was extracted, and an Si oxide (SiO₂) film 16 of 20 nm in thickness was formed using a plasma CVD apparatus.

Next, after forming the Si oxide film on the SOI wafers 10, using an apparatus for ion implantation, using conditions such that a portion of highest ion concentration was located at the interface between the Si layer 13 and the buried oxide layer 12, hydrogen ions were implanted into each wafer in doses of 3×10¹⁴ 5×10¹⁴, 1×10⁵ 5×10¹⁵, 1×10¹⁶, 3×10¹⁶, 5×10¹⁶ atoms/cm² respectively.

In addition, an SOI wafer which was not implanted with hydrogen ions was prepared. The SiGe layer 14 and the protective film were also formed in this wafer.

Next, the wafers were extracted from the implantation apparatus, and both sides of each wafer were cleaned. After that, the wafers were subjected to a heat treatment.

The wafers were treated at 500°C for 30 minutes, and after that, at 850°C for 2 hours. A nitrogen gas atmosphere was used as the atmosphere for the heat treatment.

In addition, the temperature was reduced to 700°C, and the atmosphere was changed to a nitrogen atmosphere containing oxygen at 3 mol %. After that, the temperature was increased to 1200°C, and the atmosphere was changed to an oxygen gas atmosphere. Under these conditions, the wafers were treated for 2 hours. Subsequently, the atmosphere was changed to a nitrogen atmosphere containing 3 mol % of oxygen, the temperature was reduced to 700°C, and then the SOI wafers 10 were extracted.

Next, an oxide film formed on the surface of the SOI wafer was removed using dilute HF water containing HF at 10% by weight. The solution was maintained at room temperature and the wafers were immersed in the solution for 20 minutes. After that, the wafers were immersed in pure water for 15 minutes. Immediately after spen drying of the wafer, the wafer was introduced to a lamp heater type single wafer type epitaxial growth apparatus and an Si layer of 5 nm in thickness was epitaxially grown on the surface of the SiGe layer 17. As conditions for growing the Si layer, temperature was set at 700°C, atmospheric pressure was controlled to be 2666 Pa (20 torr), and mono-silane gas was fed with hydrogen flow of 20 SLM.

For each of the above described hydrogen implantation doses, one wafer was subjected to analysis of degree of relaxation using an apparatus for Raman spectroscopy. In addition, surface roughness of each wafer was measured using AFM.

A laser beam of 443 nm in wavelength was used for the Raman spectroscopy. An area of 20µm×20µm was subjected to AFM analysis.

Next, each wafer was divided into four pieces. One piece of each wafer was etched by way of Secco etching and was analyzed for penetrating dislocation density.

Etching was carried out to the depth of 30 nm from the surface. The numbers of etch pits were counted using a differential interference microscope.

Using another piece of each wafer, thickness and Ge concentration of the SiGe layer were analyzed using SIMS.

The results are summarized in Table 3.

**Table 3.**

| | 1. | 2 | 3 | 4 | 5 | 6 | 7 | 8 |
|---|---|---|---|---|---|---|---|---|
| Hydrogen Ion Implantation atoms/cm² | nd | 3.00E+14 | 6.00E+14 | 1.00E+15 | 5.00E+15 | 1.00E+16 | 3.00E+16 | 5.00E+16 |
| Degree of Relaxation % | 35 | 60 | 70 | 70 | 70 | 70 | 70 | 70 |
| Penetrating Dislocation Density /cm² | 1.00E+07 | 7.00E+05 | 1.00E+05 | 5.00E+04 | 4.00E+04 | 4.00E+04 | 5.00E+04 | 5.00E+04 |
| Ge content atomic % | 30 | 30.1 | 30 | 30,1 | 30 | 30 | 30 | 30.1 |
| Tichkness of SiGe layer nm | 47.1 | 46.8 | 47.1 | 47 | 46.9 | 47 | 47.1 | 46.9 |
| Surface Roughness nm | 0.6 | 0.5 | 0.45 | 0.38 | 0.35 | 0.39 | 0.39 | 0.41 |

From this table, it was confirmed that compared to the wafer not implanted with hydrogen, an effect of strain relaxation was obvious in the wafer implanted with hydrogen in a dose of not less than 3 × 10¹⁴ atoms/cm² .

If the hydrogen implantation dose exceeds 5 × 10¹⁶ atoms/cm², bubbles of several µms in sizes occur in the wafer with a density of about 1 × 10⁴ /cm², and lower the surface quality.

### 4) Comparative Example 2

In Comparative Example 2, strained Si-SOI wafers were prepared for each hydrogen implantation dose described in Example 2 using conditions in which HCI free low termperature heat treatment at a temperature below 1000°C was not carried out, but the other treatments were simlar to those of Example 2.

For each of the above described hydrogen implantation doses, one wafer was subjected to analysis of degree of relaxation of SiGe using the apparatus for Raman spectroscopy. In addition, surface roughness of each wafer was measured using AFM.

A laser beam of 443 nm in wavelength was used for the Raman spectroscopy. An area of 20µm×20µm was subjected to AFM analysis,

Next, each wafer was divided into four pieces. One piece of each wafer was etched by way of Secco etching and was analyzed for penetrating dislocation density.

Etching was carried out to the depth of 30 nm from the surface. The numbers of etch pits were counted using the differential interference microscope.

Using another piece of each wafer, thickness and Ge concentration of the SiGe layer were analyzed using SIMS.

The results are summarized in Table 4.

**Table 4.**

| | 1 | 2 | 3 | 4 | 5 | 6 | 7 | 8 |
|---|---|---|---|---|---|---|---|---|
| Hydrogen Ion Implantation atoms/cm² | nd | 3.00E+14 | 5.00E+14 | 1.00E+15 | 5-00E+16 | 1.00E+16 | 3.00E+16 | 5.00E+16 |
| Degree of Relaxation % | 32 | 35 | 40 | 60 | 55 | 67 | 60 | 60 |
| Penetrating Dislocation Density /cm² | 1.00E+07 | 1-00E+06 | 5.00E+05 | 3.00E+05 | 1.00E+05 | 1.00E+05 | 1.00E+06 | 1.00E+05 |
| Ge content atomic % | 30 | 30.1 | 30 | 30. 1 | 30 | 30 | 30 | 30. 1 |
| Tichkness of SiGe layer nm | 47.1 | 46.9 | 47.01 | 46.9 | 47 | 47.06 | 47 | 46.95 |
| Surface Roughness rm | 0.6 | 0.5 | 0.51 | 0.49 | 0.49 | 0.6 | 0.49 | 0.49 |

As described above, based on the results of the examples and comparative examples, it can be understood that by the introduction of the first heat treatment step at a temperature not higher than 1000°C, the degree of relaxation of SiGe layer 18 is improved, the surface roughness is reduced, and defects are reduced in numbers.

The results also indicate that the effect of the first heat treatment on improvement of the degree of relaxation increases with decreasing thickness of the relaxed SiGe layer.

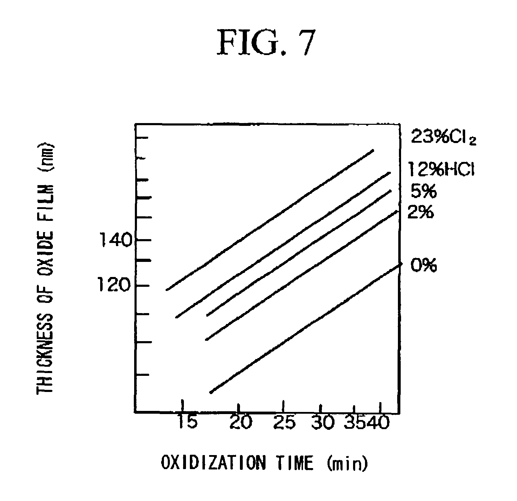

In the second heat treatment, by using the oxidizing atmosphere containing chlorine for the oxidization, the Si oxide film can be effectively grown by the oxidization of silicon, and in the SiGe layer, Ge is concentrated and the thickness is reduced in a short time period, and workability can be enhanced. FIG. 7 shows a dependency of Si oxidization on the chlorine concentration in the atmosphere. The horizontal axis shows operation time, and the longitudinal axis shows the thickness of the oxide film, Each curve indicates a result for predetermined content of chlorine in the atmosphere in the form of chlorine gas or HCl gas. FIG. 7 clearly indicates the enhancement of oxidization by addition of chlorine to the atmosphere.

Although in the above described Examples and Comparative Examples, the first and the second heat treatments were performed continuously within a heat treatment furnace while changing the atmosphere, it is possible to obtain similar effects by carrying out the heat treatment using different furnaces for the first and the second heat Treatment.

Although the wafers were implanted with hydrogen ions in the above described Experments and Comparative Experiments, similar effects can be obtained by using fluorine, neon, or helium for the ion implantation. The ratio of dose of the respective elements to the dose of hydrogen may be determined by the inverse of the ratio of the atomic weight of the element to the atomic weight of hydrogen. For example, a helium dose of one fourth of the hydrogen dose is sufficient to obtain the effects of ion implantation.

A back side or a chamfer of the wafer may have residual Ge. Such residual Ge may be removed from the back side or the chamfer before the heat treatment by polishing or by acid etching.

Although the Experiments formed an Si or SiO₂ film as a protective film, it is possible to use a multi-layered film of Si layer and vapor growth SiO₂ film.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A method for producing a strained Si-SOI substrate, comprising:
growing a SiGe mixed crystal layer on an SOI substrate having an Si layer of not less than 5 nm in thickness and a buried oxide layer;
forming a protective film on the SiGe mixed crystal layer;
implanting light element ions into a vicinity of an interface between the silicon layer and the buried oxide layer;
a first heat treatment for heat treating the substrate at a temperature of 400 to 1000°C in an inert gas atmosphere;
a second heat treatment for heat treating the substrate at a temperature not lower than 1050°C in an oxidizing atmosphere containing chlorine;
removing an Si oxide film which is formed on a surface of the substrate; and
forming a strained silicon layer on the surface of the substrate.

2. A method for producing a strained Si-SOI substrate according to claim 1, wherein the SiGe mixed crystal layer is an epitaxial layer.

3. A method for producing a strained Si-SOI substrate according to claim 1, wherein the protective film is a Si layer.

4. A method for producing a strained Si-SOI substrate according to claim 1, wherein the protective film is a SiO₂ film.

5. A method for producing a strained Si-SOI substrate according to claim 1, wherein the protective film is a multi layered film comprising at least one Si layer and at least one SiO₂ film.

6. A method for producing a strained Si-SOI substrate according to claim 1, wherein the light element is selected from a group comprising hydrogen, helium, fluorine and neon.

7. A method for producing a strained Si-SOI substrate according to claim 1, wherein the first heat treatment include low temperature treatment at a temperature range of 400 to 650°C and high temperature treatment at a temperature range of 650 to 1000°C.

8. A method for producing a strained Si-SOI substrate according to claim 1, wherein the strained Si layer is formed by epitaxial growth.

9. A method for producing a strained Si-SOI substrate according to claim 1, therein the second heat treatment satisfies a condition that a diffusion rate of Ge in Si is always higher than a formation rate of the Si oxide film_

10. A strained Si-SOI substrate that is produced by the method for producing a strained Si-SOI substrate according to claim 1.
